(19) 

Europäisches
Patentamt
European
Patent Office
Office européen
des brevets

(11) **EP 1 990 840 A1**

(12) **EUROPEAN PATENT APPLICATION**
published in accordance with Art. 158(3) EPC

(43) Date of publication:
**12.11.2008 Bulletin 2008/46**

(21) Application number: **07714347.7**

(22) Date of filing: **16.02.2007**

(51) Int Cl.:
**H01L 31/04** (2006.01)     **H01L 31/042** (2006.01)
**C09J 5/00** (2006.01)     **C09J 7/00** (2006.01)

(86) International application number:
**PCT/JP2007/052817**

(87) International publication number:
**WO 2007/094445 (23.08.2007 Gazette 2007/34)**

(84) Designated Contracting States:
**DE FR GB**

(30) Priority: **17.02.2006 JP 2006040115**

(71) Applicant: **Du Pont-Mitsui Polychemicals Co., Ltd.
Tokyo 105-7117 (JP)**

(72) Inventors:
• **NISHIJIMA, Koichi
Ichihara-shi, Chiba 299-0125 (JP)**

• **HOSOAI, Yasuhisa
Ichihara-shi, Chiba 299-0124 (JP)**
• **SHINYA, Youichi
Ichihara-shi, Chiba 299-0108 (JP)**

(74) Representative: **Cresswell, Thomas Anthony
J.A. KEMP & CO.
14 South Square
Gray's Inn
London
WC1R 5JJ (GB)**

(54) **SOLAR BATTERY SEALING MATERIAL**

(57)     The present invention provides an encapsulating material for a solar cell, which is easy to prepare a solar cell module, and excellent in processability, insulating property, non-corrosion property, transparency, heat resistance, flexibility and the like, and a solar cell module prepared by using the same. The encapsulating material for a solar cell is one consisting of a cross-linkable resin composition (A) containing an ethylene-(meth) acrylic ester copolymer as a base polymer, an organic peroxide and a crosslinking aid wherein the decomposition temperature (temperature for a half-life period of one hour) of the organic peroxide is equal to or lower than 150˚C, and total compounding amount of the organic peroxide and the crosslinking aid ,is in a range of from 0.5 to 5 parts by weight per 100 parts by weight of the base polymer, and compounding ratio of the organic peroxide and the crosslinking aid (organic peroxide/ crosslinking aid) is in a range of from 1/5 to 1/0.1, in weight ratio.

**EP 1 990 840 A1**

**Description**

TECHNICAL FIELD

The present invention relates to an encapsulating material for solar cell element in a solar cell module, and a solar cell module prepared by using the same. In more detail, the present invention relates to an encapsulating material, which is easy to prepare a solar cell module, and excellent in processability, insulating property, non-corrosion property, transparency, heat resistance, flexibility and the like.

BACKGROUND ART

Hydraulic power generation, wind power generation and photovoltaic generation, which can improve environmental problems such as reduction of carbon dioxide and the like utilizing inexhaustible natural energy, are attracting attention. Among them, photovoltaic generation has been remarkably prevailing in recent years, because in addition to significant improvements in performances such as power generation efficiency of the solar cell module, reduction in cost have been progressed, and a project to facilitate introduction of a photovoltaic generation system for housing use had been promoted by the government or municipalities.

A solar cell module is generally the one in which a solar cell element such as silicon, gallium-arsenic, copper-indium-selenium is protected with an upper transparent protection material and a lower substrate protection material, and the solar cell element and the protection material are fixed with an encapsulating material and packaged. Consequently, the encapsulating material for solar cell has been required to have good transparency in order to enhance power generation efficiency. Further, in order to avoid such troubles as flowing or deforming of the encapsulating material even when temperature rises during use of the solar cell module, it has been also required to have heat resistance. Further, suitable flexibility and excellent adhesion property have been required in order to fix stably the solar cell element.

From such view points, at present, as an encapsulating material for solar cell element in a solar cell module, a resin composition of an ethylene-vinyl acetate copolymer compounded with an organic peroxide or a silane coupling agent, is used with more than 30 years of use results. However, the ethylene-vinyl acetate copolymer has relatively high hygroscopic property, and absorbed moisture may lower, in some cases, insulation property of an encapsulating material layer, and thus lower power generation efficiency. In addition, in the case where specific conditions such as heat quantity, UV rays, moisture absorption are added, trace amount of acetic acid may be generated, in rare cases, from the ethylene-vinylacetate copolymer, which had a risk to lower power generation efficiency, caused by corrosion of an electrode, buss per, solder or the like. In addition, in a solar cell module, generally called a thin film solar cell, of amorphous silicon or microcrystal silicon, there was a risk to lower power generation efficiency, caused by corrosion of a metal oxide film such as zinc oxide used as an electrode.

Accordingly, an encapsulating material has been known already, which uses a resin composition with an ethylene-(meth)acrylic ester copolymer, as a base polymer, which has low hygroscopic property and no risk of generation of acetic acid instead of the ethylene-vinyl acetate copolymer (see, for example, Patent Literature 1). However, cross-linking of the ethylene-(meth)acrylic ester copolymer with an organic peroxide is relatively difficult to proceed, as compared with an ethylene-vinyl acetate copolymer, which thus required a large quantity of compounding of the organic peroxide, in order to obtain heat resistance similar to that of a resin composition of the ethylene-vinyl acetate copolymer, which is a base polymer. However, in the case where a large quantity of the organic peroxide is compounded to the ethylene-(meth)acrylic ester copolymer, bleed of the organic peroxide is apt to be generated, which caused a problem that productivity was significantly lowered caused by slip in sheet processing, or blister was incurred in producing a solar cell module, caused by decomposed gas of the organic peroxide.

Patent Literature 1: JP-A-6-299125

DISCLOSURE of INVENTION

PROBLEM TO BE SOLVED BY THE INVENTION

Under these circumstances, the present inventors have studied a way to obtain an encapsulating material which is excellent in heat resistance and not generates the above-described trouble in processing, in sheet molding or producing a solar cell module, even by using a resin composition with the ethylene-(meth)acrylic ester copolymer as a base polymer. As a result, it was found that the objective encapsulating material can be obtained by using a specific organic peroxide, as well as by using a cross-linking aid in combination, in specified ratio. Accordingly, it is an object of the present invention to provide an encapsulating material, which is easy to prepare a solar cell module, and excellent in processability, insulating property, non-corrosion property, transparency, heat resistance, flexibility and the like, and a solar cell module prepared by using the same.

MEANS FOR SOLVING THE PROBLEM

That is, the present invention relates to an encapsulating material for a solar cell comprising a crosslinkable resin composition (A) containing an ethylene-(meth)acrylic ester (copolymer as a base polymer, an organic peroxide and a crosslinking aid, characterized in that decomposition temperature (temperature for a half-life period of one hour) of said organic peroxide is equal to or lower than 150°C, and total compounding amount of the organic peroxide and the cross-linking co-agent is in a range of from 0.5 to 5 parts by weight per 100 parts by weight of the base polymer, and compounding ratio of the organic peroxide and the crosslinking aid (organic peroxide/crosslinking aid) is in a range of from 1/5 to 1/0.1 in weight ratio.

In addition, the present invention relates also to a solar cell module prepared by using the above-described encapsulating material.

As the above organic peroxide, it is preferable to use at least one kind selected from a dialkyl peroxide, a peroxy ester, a peroxycarbonate and a peroxyketal. In particular, it is desirable to use at least one kind of the dialkyl peroxide, and at least one kind selected from the group consisting of the peroxycarbonate and the peroxyketal are used in combination. In addition, it is preferable that, as the crosslinking aid, triallyl isocyanurate or triallyl cyanurate is used. Still more, it is desirable that at least one kind of the additive selected from a silane coupling agent, an antioxidant, a UV absorbing agent and a light stabilizer is compounded to the above-described resin composition (A).

EFFECT OF THE INVENTION

The encapsulating material for a solar cell of the present invention is excellent in processability, insulating property, non-corrosion property, transparency, heat resistance, flexibility and the like. In particular, the solar cell module prepared by using the encapsulating material of the present invention, which has low hygroscopic property and no risk of generation of acetic acid, significantly reduces lowering tendency of power generation efficiency with time, and is also capable of providing one with stable quality without corrosion of an electrode, even when used in a thin film solar cell. In addition, processing trouble in producing an encapsulating material sheet or a solar cell module can be avoided, and also an encapsulating material layer can be formed, which is excellent in heat resistance, transparency, flexibility, adhesion property or the like.

BEST MODE FOR CARRYING OUT THE INVENTION

In the present invention, an ethylene-(meth)acrylic ester copolymer is used as a base polymer of a resin composition (A), which forms an encapsulating material. As the base polymer, a small amount of other polymer, for example, an ethylene copolymer, may be compounded together, however, usually, the ethylene-(meth)acrylic ester copolymer is used alone. Here a (meth)acrylic ester in the ethylene-(meth)acrylic ester copolymer means an acrylic ester or a methacrylic ester, and an about C1 to C10 alkyl acid ester of acrylic acid or methacrylic acid is preferable. As a (meth)acrylic ester, there may be specifically exemplified methyl acrylate, ethyl acrylate, isobutyl acrylate, n-butyl acrylate, 2-ethylhexyl acrylate, methyl methacrylate, n-butyl methacrylate, or the like. A particularly suitable ethylene-(meth)acrylic ester copolymer is an ethylene-methyl acrylate copolymer, and an ethylene-ethyl acrylate copolymer. As the ethylene-(meth)acrylic ester copolymer, in consideration of transparency, flexibility, adhesion property or the like, it is preferable to use one having a polymerization unit content of the (meth) acrylic ester in an amount of from 10 to 40 parts by weight, preferably from 15 to 35 parts by weight. In addition, in consideration of processability or heat resistance, it is preferable to use one having melt flow rate (JIS K7210-1999), at 190°C and a load of 2160 g, in a range of from 0.5 to 150 g/10 minutes.

In the present invention, the above-described ethylene-(meth)acrylic ester copolymer resin (B) may be produced by any of an autoclave high pressure polymerization method and a tubular high pressure polymerization method. The tubular high pressure polymerization method is a method for radical polymerization by using a tubular reactor and a free radial catalyst under high pressure, and a method described, for example, in JP-A-62-273214 may be exemplified.

A copolymer obtained by this tubular high pressure polymerization method is characterized by satisfying, in relation between content of (meth)acrylic ester unit: X (% by mole) and melting point of the copolymer: T (°C) (melting point by a DSC method, according to JIS K 7121), the following formula:

$$-3.0X + 125 \geq T \geq -3.0X + 109$$

and has higher melting point as compared with a copolymer with an equivalent composition obtained by other polymerization method. Therefore, an encapsulating material for a solar cell, using the ethylene-(meth)acrylic ester copolymer obtained by this tubular high pressure polymerization method, is more excellent in heat resistance. In addition, an encapsulating material, in the case where a copolymer obtained by this tubular high pressure polymerization method is used, as the ethylene- (meth)acrylic ester copolymer in the present invention, is also excellent in adhesive property to glass or a polyester resin.

In the present invention, into the above-described resin composition (A), which forms an encapsulating material, an organic peroxide having a decomposition temperature (temperature for a half-life period of one hour) of equal to or lower than 150˚C, and a cross-linking aid are compounded as essential components. As a suitable organic peroxide, there is exemplified, for example, dialkyl peroxides which may be substituted with an alicyclic hydrocarbon or an aromatic hydrocarbon, such as dicumyl peroxide (135 ˚C), 1,3-bis(2-t-butylperoxyisopropyl)benzene (137˚C), 2,5-dimethyl-2,5-bis(t-butylperoxy)hexane (140˚C), t-butylcumyl peroxide (142˚C), di-tert-butyl peroxide (149˚C); a peroxy ester such as t-butylperoxy isobutyrate (102˚C), t-butylperoxy maleic acid (110˚C), 2,5-dimethyl-2,5-bis(benzoylperoxy)hexane (118˚C), t-butylperoxy acetate (123˚C), t-butylperoxy isononanoate (123˚C), t-butylperoxy benzoate(125˚C); a peroxycarbonate such as t-butylperoxy isopropyl carbonate (119˚C), t-butylperoxy 2-ethylhexyl carbonate (121˚C); a peroxyketal such as 1,1-bis(t-butylperoxy)-3,3,5-trimethylcyclohexane (112˚C), 1,1-bis(t-butylperoxy)cyclohexane (112˚C), 1,1-bis(t-amylperoxy)cyclohexane (112˚C), 2,2-bis(t-butylperoxy)butane (119˚C), n-butyl 4,4-bis(t-butylperoxy)valerate (129˚C), ethyl 3,3-di(t-butylperoxy)butyrate(135˚C); or the like (value in each parenthesis represents temperature for a half-life time of one hour). These peroxides may be used by diluting with inorganic powders or a solvent. In addition, they may be used in combination of two or more kinds. Among these, because of being particularly effective in enhancing cross-linking rate and prevention of discoloring or blister, it is preferable that at least one kind of the dialkyl peroxide, and at least one kind selected from the group consisting of the peroxycarbonate and the peroxyketal are used in combination. In this case, suitable use ratio, as represented by the dialkyl peroxide peroxide/(the peroxycarbonate and the peroxyketal), is in a range of from 10/90 to 90/10, preferably from 30/70 to 70/30, in weight ratio.

In addition, as a specific example of the cross-linking aid, a polyunsaturated compound such as a polyallyl compound or a poly(meth)acryloxy compound may be exemplified. In more specifically, there may be included a polyallyl compound such as triallyl isocyanurate, triallyl cyanurate, diallyl phthalate, dially fumarate, dially maleate; a poly(meth)acryloxy compound such as ethylene glycol diacrylate, ethylene glycol dimethacrylate, trimethylolpropane trimethacrylate; divinylbenzene or the like. Among these, in particular, it is preferable to use triallyl isocyanurate or triallyl cyanurate.

In the above-described resin composition (A) used in the encapsulating material of the present invention, it is important that total compounding amount of the organic peroxide and the crosslinking aid is set to be from 0.5 to 5 parts by weight (from 0.5 to 5.0 parts by weight), preferably from 0.5 to 4.8 parts by weight, and more preferably from 0.5 to 4 parts by weight, per 100 parts by weight of the base polymer, and compounding ratio of the organic peroxide and the crosslinking aid (organic peroxide/crosslinking aid) is set to be in a range of from 1/5 to 1/0.1, preferably from 1/4 to 1/0.5 by weight ratio. In this way, the encapsulating material layer excellent in heat resistance or adhesion property can be formed, as well as slip phenomenon in processing of an encapsulating material sheet, or blister phenomenon in producing a solar cell module can be avoided. To secure this effect, it is preferable to compound the organic peroxide in an amount of, for example, from about 0.2 to 3 parts by weight (0.2 to 3.0 parts by weight), relative to 100 parts by weight of the base polymer, and the cross-linking aid in an amount of from about 0.1 to 3 parts by weight (0.1 to 3.0 parts by weight), per 100 parts by weigh of the base polymer

To the resin composition (A), which composes the encapsulating material for a solar cell of the present invention, various additives may be compounded, if necessary. As such additives, there may be exemplified specifically, a silane coupling agent, a UV absorbing agent, a hindered phenol type or a phosphite type antioxidant, a hindered amine type light stabilizer, a light diffusing agent, a flame retardant, a discoloration inhibitor and the like may be exemplified. In particular, it is preferable that at least one kind of additive selected from a silane coupling agent, a UV absorbing agent, an antioxidant and a light stabilizer is compounded.

The silane coupling agent is useful to enhance adhesion property to a protecting material of the encapsulating material or a solar cell element or the like, and as an example thereof, there may be included a compound having an unsaturated group such as a vinyl group, an acryloxy group, a methacryloxy group; an amino group; an epoxy group; as well as a hydrolysable group such as an alkoxy group. As a silane coupling agent, there may be exemplified specifically N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane or the like. It is desirable that the silane coupling agent is compounded in an amount of from about 0.1 to 5 parts by weight, per 100 parts by weight of the base polymer.

As the UV absorbing agent which may be added to the encapsulating material for solar cell of the present invention, there may be included various types of agents such as a benzophenone type, a benzotriazole type, a triazine type, a salicylate ester type and the like. The benzophenone type UV absorbing agent includes, for example, 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, 2,2',4,4'-tetrahydroxybenzophenone or the like.

As the benzotriazole type UV absorbing agent, there may be included a hydroxyphenyl-substituted benzotriazole compound, for example, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, 2-(2-hydroxy-3,5-di-t-butylphenyl) benzotriazole and the like. In addition, as the triazine type UV absorbing agent, there may be included 2-[4,6-bis(2,4-dimethylphenyl)-1,3,5-triazine-2-yl]-5-(octy loxy)phenol, 2-(4,6-diphenyl-1,3,5-triazine-2-yl)-5-(hexyloxy)phenol or the like. As the salicylate ester type, phenyl salicylate, p-octylphenyl salicylate or the like may be included.

As the antioxidant, there may be included, for example, there may be included a hindered phenolic antioxidant such as 2,6-di-t-butyl-p-cresol, 2-t-butyl-4-methoxyphenol, 3-t-butyl-4-methoxyphenol, 2,6-di-t-butyl-4-ethylphenol, 2,2'-methylenebis(4-methyl-6-t-butylphenol), 2,2'-methylenebis(4-ethyl-6-t-butylphenol), 4;4'-methylenebis(2,6-di-t-butylphenol), 2,2'-methylenebis[6-(1-methylcyclohexyl)-p-cresol], bis[3,3-bis(4-hydroxy-3-t-butylphenyl)butyric acid] glycol ester, 4,4'-butylidenebis(6-t-butyl-m-cresol), 2,2'-ethylidenebis(4-sec-butyl-6-tert-butylphenol), 2,2'-ethylidenebis(4,6-di-tert-butylphenol), 1,1,3-tris(2-methyl-4-hydroxy-5-t-butylphenyl)butane, 1,3,5-tris(3,5-di-t-butyl-4-hydroxybenzyl)-2,4,6-trimethylb enzene, 2,6-diphenyl-4-octadecyloxyphenol, Tetrakis[methylene-3-(3,5-di-t-butyl-4-hydroxyphenyl) propio nate]methane, n-octadecyl 3-(3,5-di-t-butyl-4-hydroxyphenyl)propionate, 4,4'-thiobis(6-t-butyl-m-cresol), tocopherol, 3,9-bis[1,1-dimethyl-2-[β-(3-t-butyl-4-hydroxy-5-methylphen yl)propionyloxy]ethyl]-2,4,8,10-tetraoxaspiro[5,5] undecane, 2,4,6-tris(3,5-di-tert-butyl-4-hydroxybenzylthio)-1,3,5-tri azine.

As the light stabilizer, a hindered amine type is suitable, and not only one with low molecular weight but also one with high molecular weight may be used. In addition, they may be used not only as one kind but also as two or more kinds in combination. As the low molecular weight hindered amine, there may be included, for example, 4-acetoxy-2,2,6,6-tetramethylpiperidine, 4-stearoyloxy-2,2,6,6-tetramethylpiperidine, 4-acryloyloxy-2,2,6,6-tetramethylpiperidine, 4-benzoyloxy-2,2,6,6-tetramethylpiperidine, 4-benzyloxy-2,2,6,6-tetramethylpiperidine, 4-cyclohexanoyloxy-2,2,6,6-tetramethylpiperidine, 4-(phenylacetoxy)-2,2,6,6-tetramethylpiperidine, 4-(o-chlorobenzoyloxy)-2,2,6,6-tetramethylpiperidine, 4-(phenoxyacetoxy)-2,2,6,6-tetramethylpiperidine, 4-(phenylcarbamoyloxy)-2,2,6,6-tetramethylpiperidine, 4-(p-toluenesulfonyloxy)-2,2,6,6-tetramethylpiperidine, 4-nicotinoyloxy-2,2,6,6-tetramethylpiperidine, 4-(2-furoyloxy)-2,2,6,6-tetramethylpiperidine, 4-(β-naphthoyloxy)-2,2,6,6-tetramethylpiperidine, 1,3,8-triaza-7,7,9,9-tetramethyl-2,4-dioxo-3-n-octyl-spiro[ 4,5]decane, bis(2,2,6,6-tetramethyl-4-piperidyl) adipate, bis(2,2,6,6-tetramethyl-4-piperidyl) sebacate, bis(2,2,6,6-tetramethyl-4-piperidyl) hexahydrotelephthalate, bis(2,2,6,6-tetramethyl-4-piperidyl) telephthalate, bis(1,2,2,6,6-pentamethyl-4-piperidyl) sebacate, tris(2,2,6,6-tetramethyl-4-piperidyl)benzene-1,3,5-tricarbo xylate, tris(2,2,6,6-tetramethyl-4-piperidyl)-2-acetoxypropane-1,2, 3-tricarboxylate, tris(2,2,6,6-tetramethyl-4-piperidyl)-2-hydroxypropane-1,2, 3-tricarboxylate, tris(2,2,6,6-tetramethyl-4-piperidyl)triazine-2,4,6-tricarb oxylate, tris(2,2,6,6-tetramethyl-4-piperidyl) phosphite, tris(2,2,6,6-tetramethyl-4-piperidyl)butane-1,2,3-tricarbox ylate, tetrakis(2,2,6,6-tetramethyl-4-piperidyl)-propane-1,1,2,3-t etracarboxylate, tetrakis(2,2,6,6-tetramethyl-4-piperidyl) butane-1,2,3,4-tetracarboxylate, (2,2,6,6-tetramethyl-4-piperidine)-4-spiro-2'-(6',6'-dimeth ylpiperidine)-4'-spiro-5''-hydantoin or the like. In more specifically, one available on the market under the trade name such as Sanol LS770, Tinuvin 144, Adecastab LA-57, Adecastab LA-62, Adecastab LA-67, Goodlite UV-3034 may be used. In addition, as the high molecular weight hindered amine having over 1000 of molecular weight, one available on the market under the trade name such as Cyasorb UV3346, Chimassorb 944LD, Tinuvin 622LD may be used.

Using the encapsulating material for solar cell of the present invention, a solar cell module can be manufactured by fixing a solar cell element with upper and lower protective materials. As such solar cell module, various types can be exemplified. For example, the one having such structure that a solar cell element is sandwiched from the both sides thereof with encapsulating material in such manner as upper transparent protective material / encapsulating material / solar cell element / encapsulating material / lower protective material; the one having such structure that an encapsulating material and an upper transparent protective material are formed on a solar cell element which is formed on the inner surface of a lower substrate protective material; the one having such structure that an encapsulating material and a lower protective material are formed on a solar cell element which is formed on the inner surface of an upper transparent protective material, for example, an amorphous solar cell element formed on a fluorinated-resin-based protective material by sputtering or the like; and the like.

As the solar cell element, various types of solar cell elements may be used: for example, there may be exemplified a silicon type such as single crystal silicon, polycrystalline silicon, amorphous silicon and microcrystal silicon, and a hybrid type or a thin film type prepared by combination thereof; a compound semiconductor type of III - V groups or II - VI groups, such as gallium-arsenic, copper-indium-selenium, cadmium-tellurium; and the like. As a metal oxide to be used as a transparent electrode, zinc oxide, stannous oxide, indium oxide and one which some kind of element is doped on these oxides, can be exemplified.

As the upper protective material constructing the solar cell module, glass, acrylic resin, polycarbonate, polyester, fluorine-containing resin and the like can be exemplified. As for glass, because of having advantage in power generation efficiency, glass in which $CeO_2$ having UV absorption capability is not added, may be shown as a suitable example. The lower protective material is a sheet of simple body or multilayer of a metal or various types of thermoplastic resin films, and for example, a single layer or a multilayer of protective material of metal such as tin, aluminium, stainless steel and the like; inorganic material such as glass and the like; polyester; polyester vapor-evaporated with inorganic substance; fluorine-containing resin; polyolefin; and the like can be exemplified.

The encapsulating material for the solar cell of the present invention is used in a sheet form, with a thickness of usually from 0.1 to 1.5 mm, preferably from about 0.1 to 1 mm. The sheet-like encapsulating material for the solar cell, composed of the resin composition (A), may be produced by the known sheet molding method using a T-die extruder, a calendering machine or the like. For example, the above sheet may be obtained by dry blending an ethylene-(meth) acrylic ester copolymer, an organic peroxide and a crosslinking aid, along with additives to be added, if necessary, such as a silane coupling agent, a UV absorbing agent, an antioxidant, a light stabilizer and the like, in advance, and supplying the mixture from the hopper of a T-die extruder, then extruding in a sheet-like form. In the dry blending, a part of or all of the additives may be used in a master-batch form. In addition, in the T-die extrusion or calendering, a resin composition, which is obtained by melt blending a resin component with a part of or all of the additives using single-screw extruder, twin-screw extruder, Banbury mixer, kneader and the like in advance, can be used.

In producing the solar cell module, the module having the aforementioned composition may be formed by a similar method to a conventional one, in which sheets of the encapsulating material of the present invention is prepared in advance, and pressure-bonded at temperature at which the encapsulating material melts. That is, the encapsulating material may be tentatively adhered to the solar cell element or the protection material, at temperature for not substantially decomposing the cross-linking agent and melting the encapsulating material of the present invention, and then subjected to sufficient adhesion and cross-linking of the ethylene- (meth) acrylic ester copolymer, by raising temperature. In this case, in order to obtain the solar cell module excellent in heat resistance, cross-linking may be carried out so that gel fraction (one gram of sample is immersed in 100 ml of xylene and treated at 110˚C for 24 hours, and then filtered by 20 mesh metal screen, and undissolved mass fraction is measured) in encapsulating material layer is 50 to 98 %, preferable about 70 to 95%.

EXAMPLES

Explanation will be given below in still more detail on the present invention with reference to Examples. It should be noted that the raw materials and evaluation methods for physical properties used in Examples are as follows.

1. Raw materials

(1) EEA (an ethylene-ethyl acrylate copolymer, ethyl acrylate unit content 25 % by weight, melt flow rate at 190˚C under a load of 2160 g (JIS K7210-1999) is 15 g/10 minutes)
(2) Organic peroxide
Organic peroxide (1): 2,5-dimethyl-2,5-bis(t-butylperoxy)hexane
Organic peroxide(2): t-butylperoxy-2-ethylhexyl carbonate
Organic peroxide(3): 1,1-bis(t-butylperoxy)cyclohexane
(3) Cross-linking aid
Cross-linking aid (1): triallyl isocyanurate
Cross-linking aid (2): triallyl cyanurate
(4) Silane coupling agent:

γ-(methacryloxypropyl)trimethoxysilane

(5) UV absorbing agent:
2-hydroxy-4-ocloxy-benzophenone.
(6) Light stabilizer:

bis(2,2,6,6-tetramethyl-4-piperidyl) sebacate

2. Evaluation items

(1) Processability

Processability in sheet processing was evaluated by the following standards:

○ It is processable without any problem.
✕ Processing is unstable caused by surging or the like.

(2) Gel fraction

A press sheet with a thickness of 1 mm was prepared under condition of 150˚C for 15 minutes, and about 1 g was cut out therefrom and weighed accurately. It was immersed in 100 mL of xylene to be subjected to processing at 110˚C for 24 hours, and an undissolved portion, after filtering with a 20 mesh metal screen, was weighed accurately. Gel fraction was calculated by dividing the residual weight with sample weight before processing.

(3) Blister

On blue-colored glass (with a thickness of 3 mm, 12 cm✕ 7.5 cm), a sheet prepared in each Example was put, and two aluminum plates with a side of 3 cm (with a thickness of 0.5: intended to look like a cell) were placed thereon in an interval of 1 cm, which were fixed with a pressure sensitive adhesive tape made of a polytetrafluoroethylene substrate. Then, the sheet prepared in each Example was put further thereon, and finally a PET-type back-sheet was laminated and adhered at 150˚C for 5 minutes. Then, after curing at 140˚C for 1 hour, appearance was observed and evaluated according to the following standards:

○: no particular change of appearance
Δ: generation of a little shape change at a position adhered with the pressure sensitive adhesive tape
✕: generation of blister at a position adhered with the pressure sensitive adhesive tape

Example 1

At three hours after mixing the above ethylene-ethyl acrylate copolymer (EEA), an organic peroxide (3), a crosslinking aid (1), a silane coupling agent, a UV absorbing agent and a light stabilizer, in advance, in ratios shown in Table 1, the mixture was subjected to preparation of a sheet with a thickness of 0.6 mm, by using a T-die extruder (screw diameter=40 mm, fully flighted screw, CR=2.6, L/D=26) at a processing temperature of 100˚C. Using this sheet, various evaluations described above were carried out. Results are shown in Table 1.

Example 2

A sheet was formed similarly to in Example 1, except that use amount of the organic peroxide (3) and the crosslinking aid (1) were changed as shown in Table 1, and the evaluations thereof were carried out. Results are shown in Table 1.

Example 3

A sheet was formed o as in Example 2, except that the organic peroxide (2) was used in ratio shown in Table 1, instead of using the organic peroxide (3), and the evaluations thereof were carried out. Results are shown in Table 1.

Example 4

A sheet was formed similarly to in Example 2, except that the organic peroxide (1) and the organic peroxide (2) were used in ratios shown in Table 1, instead of using the organic peroxide (3), and the evaluations thereof were carried out. Results are shown in Table 1.

Example 5

A sheet was formed similarly to in Example 1, except that the crosslinking aid(2) was used instead of using the crosslinking aid(1), and use amount of the UV absorbing agent was changed to ratio shown in Table 1, and the evaluations thereof were carried out. Results are shown in Table 1.

Comparative Example 1

A sheet was formed similarly to in Example 1, except that use amounts of the organic peroxide (3) and the UV absorbing agent were changed to ratios shown in Table 1, and the crosslinking aid(1) was not used, and the evaluations thereof were carried out. Results are shown in Table 1.
Table 1

| | Example | | | | | Com. Exam. |
|---|---|---|---|---|---|---|
| | 1 | 2 | 3 | 4 | 5 | 1 |
| EEA | 100 | 100 | 100 | 100 | 100 | 100 |
| Organic Peroxide (1) | | | | 0.5 | | |
| Organic Peroxide (2) | | | 1.08 | 1.08 | | |
| Organic Peroxide (3) | 1 | 1.5 | | | 1 | 2.5 |
| Crosslinking aid(1) | 1.6 | 0.8 | 0.8 | 0.8 | | |
| Cross-linking aid (2) | | | | | 1.6 | |
| Silane coupling agent | 0.2 | 0.2 | 0.2 | 0.2 | 0.2 | 0.2 |
| UV absobing agent | 0.3 | 0.3 | 0.3 | 0.3 | 0.1 | 0.1 |
| Light stabilizer | 0.1 | 0.1 | 0.1 | 0.1 | 0.1 | 0.1 |
| Weight ratio: Organic peroxide/ Cross-linking aid | 1/1.6 | 1/0.53 | 1/1.11 | 1/0.5 | 1/1.6 | - |
| Processability | ○ | ○ | ○ | ○ | ○ | ○ |
| Gel fraction (%) | 74 | 75 | 74 | 78 | 73 | 65 |
| Blister test | ○ | Δ | ○ | ○ | ○ | × |

Example 6

At three hours after mixing the ethylene-methyl acrylate copolymer (EMA(1)) shown in Table 2, an organic peroxide (2), a crosslinking aid(1), a silane coupling agent, in advance, in ratios shown in Table 2, the mixture was subjected to preparation of a sheet with a thickness of 0. 6 mm, by using a T-die extruder (screw diameter=40 mm, fully flighted screw, CR=2.6, L/D=26) at a processing temperature of 100˚C. Using this sheet, various evaluations described above were carried out. Results are shown in Table 3.

Example 7

A sheet was formed similarly to in Example 1, except that the ethylene-methyl acrylate copolymer (EMA(2)) shown in Table 2 was used, and use amounts of the organic peroxide (1), the organic peroxide (2) and the cross-linking aid were changed to ratios shown in Table 2, and the evaluations thereof were carried out. Results are shown in Table 3.
Table 2

| | EMA (1) | EMA (2) |
|---|---|---|
| X: Comonomer content (mol %) | 9.36 | 12.2 |
| Comonomer content (wt. %) | 24 | 30 |
| Melt flow rate (g/10 m) | 20 | 15 |
| -3.0X + 125 | 96.9 | 88.4 |
| T: Melting point (˚C) | 88 | 84 |

(continued)

| | EMA (1) | EMA (2) |
|---|---|---|
| -3.0X + 109 | 80.9 | 72.4 |
| Hardness (Shore A) | 78 | 68 |
| Production method | Tubular method | Tubular method |
| (Note) EMA: An ethylene-methyl acrylate copolymer | | |

Table 3

| | Example | |
|---|---|---|
| | 6 | 7 |
| EMA (1) | 100 | |
| EMA (2) | | 100 |
| EEA | | |
| Organic Peroxide (1) | | 2 |
| Organic Peroxide (2) | 0.72 | 0.5 |
| Crosslinking aid | 1.6 | 2 |
| Silane coupling agent | 0.5 | 0.5 |
| Weight ratio: Org. peroxide/ Crosslinking aid | 1/2.22 | 1/0.8 |
| Processability | ○ | ○ |
| Gel fraction (%) | 65 | 87 |
| Blister test | ○ | ○ |

INDUSTRIAL APPLICABILITY

According to the present invention, there is provided an encapsulating material for solar cell element excellent in processability, insulating property, non-corrosion property, transparency, heat resistance, flexibility and the like.

The solar cell module prepared by using the encapsulating material of the present invention, which has particularly low hygroscopic property and no risk of generation of acetic acid, significantly reduces lowering tendency of power generation efficiency in time course, and is also capable of providing one with stable quality without corrosion of an electrode, even when used in a thin film solar cell.

In addition, processing trouble in producing an encapsulating material sheet or the solar cell module can be avoided, and also an encapsulating material layer can be formed, which is excellent in heat resistance, transparency, flexibility, adhesion property or the like.

**Claims**

1. An encapsulating material for a solar cell comprising a crosslinkable resin composition (A) containing an ethylene-(meth)acrylic ester copolymer as a base polymer, an organic peroxide and a crosslinking aid, **characterized in that** decomposition temperature (temperature for a half-life period of one hour) of said organic peroxide is equal to or lower than 150˚C, and total compounding amount of the organic peroxide and the crosslinking aid is in a range of from 0.5 to 5 parts by weight per 100 parts by weight of the base polymer, and compounding ratio of the organic peroxide and the crosslinking aid (organic peroxide/crosslinking aid) is in a range of from 1/5 to 1/0.1 in weight ratio.

2. The encapsulating material for a solar cell according to claim 1, wherein the organic peroxide is at least one kind selected from a dialkyl peroxide, a peroxy ester, a peroxycarbonate and a peroxyketal.

3. The encapsulating material for a solar cell according to claim 2, **characterized in that**, as the organic peroxide, at least one kind of the dialkyl peroxide, and at least one kind selected from the group consisting of the peroxycarbonate and the peroxyketal are used in combination.

4. The encapsulating material for a solar cell according to any one of claims 1 to 3, wherein the cross-linking aid is triallyl isocyanurate or triallyl cyanurate.

5. The encapsulating material for a solar cell according to any one of claims 1 to 4, **characterized by** compounding at least one kind of additive selected from a silane coupling agent, an antioxidant, a UV absorbing agent and a light stabilizer, to the resin composition (A).

6. A solar cell module prepared by using the encapsulating material for a solar cell according to any one of claims 1 to 5.

7. The solar cell module according to claim 6, wherein a surface protecting material not containing cerium oxide is used.

8. The solar cell module according to claim 6 or 7, wherein amorphous silicon, microcrystal silicon and thin film-type silicon made of a combination thereof, or a compound-type semiconductor such as gallium-arsenic or copper-indium-selenium is used as a solar cell element, and a metal oxide film is used as a transparent electrode.

| **INTERNATIONAL SEARCH REPORT** | International application No. |
|---|---|
| | PCT/JP2007/052817 |

A.   CLASSIFICATION OF SUBJECT MATTER
*H01L31/04(2006.01)i, H01L31/042(2006.01)i, C09J5/00(2006.01)i, C09J7/00 (2006.01)i*

According to International Patent Classification (IPC) or to both national classification and IPC

B.   FIELDS SEARCHED

Minimum documentation searched (classification system followed by classification symbols)
*H01L31/04(2006.01)i-H01L31/078(2006.01)i, C09J1/00(2006.01)i-C09J201/10(2006.01)i*

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>Y | JP 6-299125 A  (Du Pont-Mitsui Polychemicals Co., Ltd.),<br>25 October, 1994 (25.10.94),<br>Par. Nos. [0011] to [0015]<br>(Family: none) | 1-6,8<br>7 |
| Y | JP 5-82822 A  (Nippon Electric Glass Co., Ltd.),<br>02 April, 1993 (02.04.93),<br>Par. No. [0021]<br>(Family: none) | 7 |
| A | JP 2006-36874 A  (Du Pont-Mitsui Polychemicals Co., Ltd.),<br>09 February, 2006 (09.02.06),<br>Par. Nos. [0015] to [0017]<br>(Family: none) | 1-8 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 08 March, 2007 (08.03.07) | 20 March, 2007 (20.03.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

| INTERNATIONAL SEARCH REPORT | International application No. |
|---|---|
| | PCT/JP2007/052817 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 8-148708 A  (Sekisui Chemical Co., Ltd.), 07 June, 1996 (07.06.96), Par. Nos. [0043], [0072] (Family: none) | 1-8 |
| A | JP 10-321886 A  (Shibata Kogyo Kabushiki Kaisha), 04 December, 1998 (04.12.98), Par. Nos. [0011], [0017] (Family: none) | 1-8 |
| A | JP 2005-126708 A  (Du Pont-Mitsui Polychemicals Co., Ltd.), 19 May, 2005 (19.05.05), Par. Nos. [0017] to [0019] (Family: none) | 1-8 |
| A | JP 5-186610 A  (Mitsubishi Petrochemical Co., Ltd.), 27 July, 1993 (27.07.93), Full text (Family: none) | 1-8 |
| A | JP 8-316508 A  (Du Pont-Mitsui Polychemicals Co., Ltd.), 29 November, 1996 (29.11.96), Par. No. [0017] (Family: none) | 1-8 |
| A | JP 9-92759 A  (Canon Inc.), 04 April, 1997 (04.04.97), Full text & US 6130379 A          & EP 0755079 A2 | 1-8 |
| A | JP 10-338841 A  (Bridgestone Corp.), 22 December, 1998 (22.12.98), Par. No. [0016] (Family: none) | 1-8 |
| A | JP 2001-77390 A  (Canon Inc.), 23 March, 2001 (23.03.01), Full text & US 6414236 B1          & EP 1065731 A2 | 1-8 |
| A | JP 7-58355 A  (Optical Coating Laboratory Inc.), 03 March, 1995 (03.03.95), Full text & US 5449413 A          & EP 0632507 A2 | 7 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6299125 A
- JP 62273214 A